# FASCICULE DE BREVET EUROPEEN

(11) **EP 0 787 994 B1**
(45) Date de publication et mention de la délivrance du brevet: **17.03.1999**
(21) Numéro de dépôt: 97100397.5
(22) Date de dépôt: 11.01.1997
(51) Int. Cl.: G01R 21/133

(54) **Compteur de consommation électrique**
Stromzähler
Electricity meter

(30) Priorité: 01.02.1996 FR 9601449
(43) Date de publication de la demande: 06.08.1997
(73) Titulaire: STMicroelectronics S.A., 94250 Gentilly (FR)
(72) Inventeur: Le van Suu, Maurice, 57000 Metz (FR)
(74) Mandataire: Schmit, Christian Norbert Marie

(56) Documents cités:
- EP-A- 0 446 962
- AT AUTOMATISIERUNGSTECHNIK Mars 1994, MUNCHEN,DE, XP000435853 FRANKE 'parallel fucs: Einsatzsystem zur On-line- und Real-time-Fuzzy-Klassifikation'

## Description

L'invention concerne un compteur de consommation électrique destiné à établir de manière précise la consommation d'une installation électrique donnée.

Les compteurs de consommation électrique connus sont de deux types, soit électromécanique, soit électronique. Les compteurs électromécaniques utilisent un petit moteur qui tourne à une vitesse correspondant à la puissance consommée. Le petit moteur entraîne un compteur mécanique qui mémorise la puissance totale consommée. Les pertes mécaniques dues aux frottements rendent le système insensible à de faibles courants, inférieurs à 70mA, ceci correspondant à une non-facturation sur des puissances inférieures à 15,4 W. L'étalonnage de ces compteurs est relativement long et ne permet pas de recalibrer le compteur après une certaine usure. De plus les éléments mécaniques sont relativement couteux.

Les compteurs électroniques visent à supprimer certains défauts des compteurs électromécaniques. Ainsi les compteurs électroniques ont une limite de sensibilité plus faible. Le document EP-A-0 446 962 décrit un compteur électronique utilisant un microprocesseur, un circuit de mesure de la puissance consommée, une mémoire et un afficheur. Leur fabrication est moins coûteuse. Il est possible de recalibrer le compteur suite à une dérive des composants. Néanmoins les opérations de calibrage prennent un temps important (réglage de potentiomètres) et le recalibrage d'un appareil ne peut pas être fait sur son site d'utilisation.

Par ailleurs les processeurs à logique floue et le concept flou sont connus pour prendre des décisions en fonction de paramètres d'entrées peu ou pas linéaire pouvant prendre plusieurs valeurs pour une zone de courbe à un fonctionnement donné.

L'invention a pour but de réaliser un compteur électronique visant à diminuer le temps d'étalonnage et permettant un recalibrage sur site du compteur grâce à une phase d'apprentissage. La phase d'apprentissage consiste à adapter le comportement du système en fonction de la variation et/ou de la dérive des variables d'entrées. Le compteur selon l'invention utilise la logique floue pour effectuer la mesure et corriger les éventuelles erreurs de mesure. De plus le compteur est ré-étalonnable sur site.

Ainsi l'invention a pour objet un compteur de consommation électrique comportant une sonde de courant, une sonde de tension et un afficheur mémorisant son contenu, caractérisé en ce que ledit compteur comporte un processeur à logique floue ayant un calculateur de prise de décision en logique floue disposant d'une mémoire non volatile pour stocker des fonctions d'appartenance correspondant aux premières sondes de tension et de courant et pour stocker des règles de décision et en ce que ledit calculateur prend une décision suivant lesdites règles qui est pondérée par les fonctions d'appartenance et qui a pour but d'incrémenter le contenu de l'afficheur.

L'utilisation de la logique floue permet d'accélérer l'étalonnage de l'appareil par une méthode d'apprentissage. De plus le processeur à logique floue permet de traiter des opérations plus complexes au niveau de la facturation que ce qu'il était possible de faire avec les compteurs classiques. Le compteur à logique floue peut de plus décoder des messages issus d'une modulation en courant porteur.

Très facilement, on peut transposer le compteur monophasé en compteur triphasé.

De plus un tel compteur peut subir un ré-étalonnage sur site en branchant un appareil étalon qui mesure la même puissance que le compteur et communique au compteur une information de dérive de puissance que le compteur additionnera par la suite à chaque mesure de puissance.

L'invention sera mieux comprise et d'autres particularités et avantages apparaîtront dans la description qui suit d'un mode de réalisation de l'invention, donné à titre indicatif et nullement limitatif, à lire conjointement aux dessins annexé, parmi lesquels:
la figure 1 est un schéma d'un compteur conforme à l'invention,
les figures 2a et 2b représentent des fonctions d'appartenance utilisables dans ce compteur.

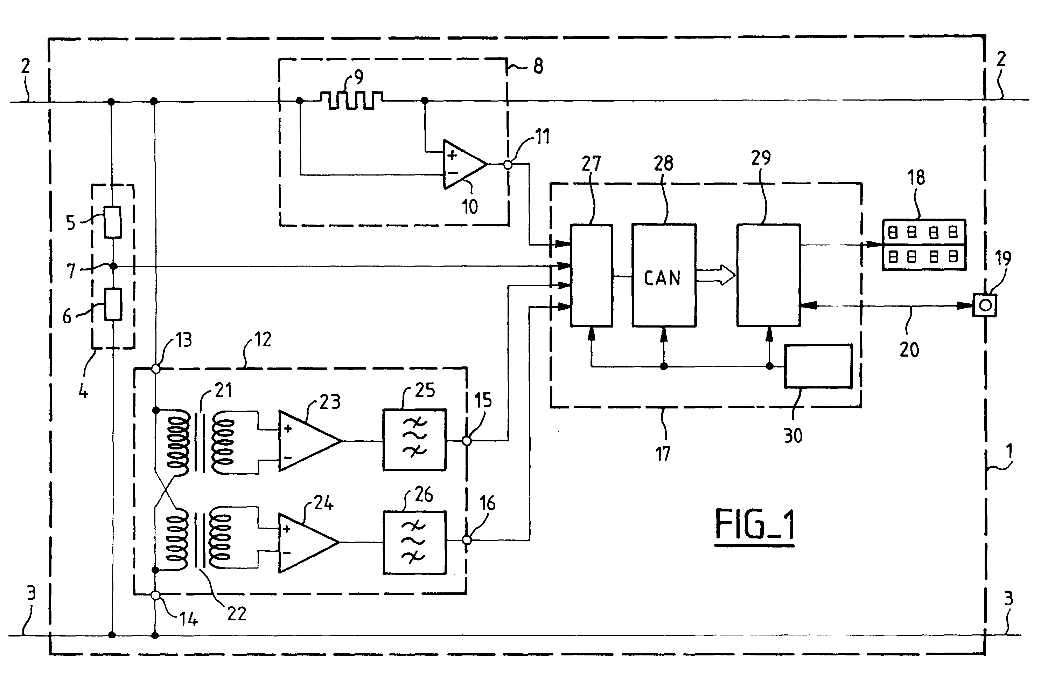

Le compteur 1, représenté sur la figure 1, est traversé par deux fils électriques 2 et 3 transportant le secteur, le fil 2 étant relié à la phase et le fil 3 étant relié au neutre. Le compteur 1 comporte:
- une sonde de tension 4, constituée d'un pont diviseur de tension formé de deux résistances 5 et 6, la résistance 5 ayant l'une de ses bornes connectée à la phase 2 et l'autre de ses bornes connectée à une borne de sortie 7 de la sonde de tension 4, la résistance 6 ayant l'une de ses bornes connectée au neutre 3 et l'autre de ses bornes connectée à la borne de sortie 7 de la sonde de tension 4,
- une sonde de courant 8, constituée d'une résistance de shunt 9 inséré sur le fil 2 transportant la phase et d'un amplificateur différentiel 10 ayant deux entrées et une sortie, chacune des deux entrées de l'amplificateur 10 étant connectée à l'une des bornes de la résistance de shunt 9 et la sortie de l'amplificateur 10 étant connectée à la borne de sortie 11 de la sonde de courant 8,
- un circuit 12 de récupération de signaux en courant porteur ayant deux bornes d'entrées 13 et 14 et deux bornes de sortie 15 et 16, la borne d'entrée 13 étant reliée à la phase 2 et la borne d'entrée 14 étant reliée au neutre 3,
- un processeur à logique floue 17 ayant quatre entrées de signaux analogiques, une sortie d'information et une entrée/sortie de communication, la première entrée de signal étant connectée à la borne 11 de la sonde de courant 8, la deuxième entrée de signal étant connectée à la borne 7 de la sonde de tension 4, les troisième et quatrième entrées de signaux étant connectées respectivement aux bornes 15 et 16 du circuit 12,
- un système 18 d'affichage et de mémorisation ayant une entrée connectée à la sortie d'information du processeur 17, et
- un connecteur 19 relié à l'entrée/sortie de communication du processeur 17 par l'intermédiaire d'un bus 20.

Il convient que l'accès au connecteur 19 soit réservé à un personnel autorisé par exemple par l'utilisation d'un cache avec un plombage.

La résistance de shunt 9 n'a pas besoin d'être très précise, on peut par exemple utiliser une résistance précise à 10% et réaliser directement celle-ci sur un morceau de métal.

Les modes de réalisation des sondes de tension 4 et de courant 8 ont été choisis pour leur simplicité. Un éventail de sondes plus ou moins précises peut être substitué aux sondes que nous avons retenues. Certaines modifications destinées à adapter ces autres sondes au circuit sont à prévoir mais présentent peu d'intérêt par rapport à l'invention.

Le circuit 12 est ici constitué de deux transformateurs 21 et 22 ayant chacun un enroulement primaire et un enroulement secondaire. Les enroulements primaires des deux transformateurs 21 et 22 sont connectés en parallèle entre les bornes 13 et 14. l'enroulement secondaire de chaque transformateur 21 et 22 est connecté aux entrées d'amplificateurs différentiels 23 et 24. La sortie de chacun des amplificateurs 23 et 24 est respectivement connectée à l'entrée d'un filtre passe-bande 25 et 26. Le filtre passe-bande 25 a pour fréquences de coupure par exemple 175 Hz et 188 Hz. Le filtre passe-bande 26 a une fréquence centrale par exemple de 60 kHz. Les fréquences de 175 Hz et 188 Hz correspondent à la largeur de bande du message de changement de tarification jour/nuit en France, et la fréquence de 60 kHz et une fréquence qui sert à transmettre des messages par courant porteur. Le transformateur 21 servant à récupérer le signal de 175 et 188 Hz peut être le même transformateur que celui servant à l'alimentation du compteur 1. L'autre transformateur 22 sera de type résonant (éventuellement muni de capacités) à la fréquence de 60 kHz, dans ce cas le filtre passe-bande 26 peut être remplacer par un filtre passe bas dont la sortie délivrera le signal démodulé.

Le processeur à logique floue 17 comporte:
- un commutateur 27 analogique quatre entrées pour une sortie ayant des entrées de sélection,
- un convertisseur 28 analogique/numérique qui convertit une donnée analogique en donnée numérique codée préférentiellement sur 16 bits (12 bits signés est le minimum demandé), le convertisseur comporte une entrée analogique, une sortie numérique sur 16 bits, et une entrée de synchronisation,
- un calculateur 29 de décisions en logique floue, ce composant pourra être par exemple un composant commercialisé par la société dite SGS THOMSON MICROELECTRONICS S.A. sous le nom générique de W.A.R.P., un tel composant dispose d'une mémoire non volatile et de registres internes architecturés en 16 bits et dispose d'une sortie numérique, d'une entrée/sortie série, d'une entrée numérique et d'entrées de synchronisation.

Le commutateur 27 a ses entrées analogiques qui sont les entrées analogiques du processeur à logique floue 17 et sa sortie analogique connectée à l'entrée analogique du convertisseur 28. La sortie du convertisseur 28 est connectée à l'entrée numérique du calculateur 29. L'entrée/sortie série du calculateur 29 est l'entrée/sortie de communication du processeur à logique floue 17. Un circuit de synchronisation 30 envoie sur l'entrée de sélection du commutateur 27 ainsi que sur les entrées de synchronisation du convertisseur 28 et du calculateur 29 des signaux servant à l'échantillonnage et à la conversion numérique des différents signaux d'entrée.

Le système d'affichage 18 est ici constitué de deux afficheurs (tarif heures creuses/heures pleines). De plus le système d'affichage est muni de deux compteurs électroniques dont l'alimentation est sauvegardée par une batterie auxiliaire (non représenté). En fonction du signal envoyé en entrée, aucun des deux compteurs ne compte, ou l'un des deux s'incrémente d'une unité. Le système d'affichage 18 sert également d'élément de mémorisation.

Certains éléments ont été volontairement omis ou simplifiés dans le but de clarifier l'aspect fonctionnel du schéma. Ainsi l'alimentation des différents éléments du compteur n'est pas représentée de même que certaines connexions nécessaire au transport de signaux de synchronisation. L'entrée/sortie de communication est en fait constituée de plusieurs fils et correspond à une communication de type série classique. La sonde de courant est placée sur le fil 2 de phase ce qui devrait nécessiter l'ajout de moyens de protection vis à vis de l'amplificateur 10 qui ne sont pas représentées.

L'homme de métier peut substituer certains éléments au profit d'autres montages connus et fonctionnellement équivalent. Les explications qui vont suivre seront à adapter en fonction de ces éventuelles modifications.

La mesure de la puissance consommée correspond à la valeur de l'intégrale de la puissance instantanée. Pour réaliser cette intégrale, on utilise la méthode de Riemans qui consiste à faire la somme des puissances instantanées sur de très courtes durées par exemple 1 ms. La sommation a donc un résultat par exemple en W.ms qui est stocké dans des registres du processeur à logique floue 17 (par exemple deux mots de 16 bits). Chaque fois que le résultat accumulé dépasse 1 kW.H, c'est à dire 3 600 000 W.ms on incrémente de une unité l'un des compteurs de l'afficheur en fonction de la tarification en vigueur. Le fait d'utiliser une même variable pour la tarification heures creuses/heures pleines peut paraître incorrect, aussi l'homme de métier est libre d'utiliser une ou deux variables (2 ou 4 mots de 16 bits). En ce qui concerne l'exemple de réalisation de la figure 1, il a été choisi de n'utiliser qu'une seule variable dans le processeur, en effet l'erreur porte sur moins de 1 kW.H et se produit à priori autant à l'avantage des deux parties (client et fournisseur).

L'innovation apportée par le processeur à logique floue 17 vient essentiellement du fonctionnement du calculateur 29. En effet le calculateur 29 traite les variables d'entrée à l'aide de fonctions d'appartenance et de règles générant des décisions pondérés par les fonctions d'appartenance.

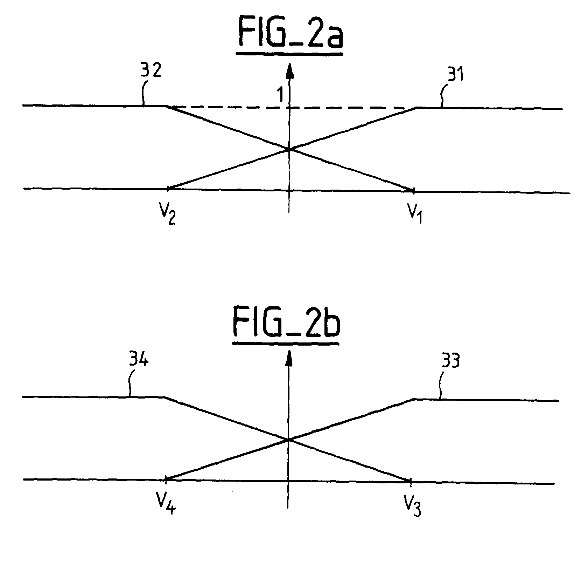

Les fonctions d'appartenance peuvent être dans l'exemple très simplifiées car les sondes de courant 8 et de tension 4 sont de type linéaire. Il va de soit que si ces sondes ne sont pas linéaires, les fonctions d'appartenance seront plus nombreuses. Les fonctions d'appartenance relatives aux sondes de courant 8 et de tension 4 sont représentées respectivement sur les figures 2a et 2b.

La fonction d'appartenance 31 vaut 1 pour les tensions supérieures à un seuil de tension V1, est nulle pour les tensions inférieures à un seuil de tension V2, et croit linéairement de 0 à 1 pour des tensions allant respectivement de V2 à V1. La fonction d'appartenance 32 vaut 1 pour les tensions inférieures à un seuil de tension V2, est nulle pour les tensions supérieures à un seuil de tension V1, et décroît linéairement de 1 à 0 pour des tensions allant respectivement de V2 à V1. La fonction d'appartenance 33 vaut 1 pour les tensions supérieures à un seuil de tension V3, est nulle pour les tensions inférieures à un seuil de tension V4, et croit linéairement de 0 à 1 pour des tensions allant respectivement de V4 à V3. La fonction d'appartenance 34 vaut 1 pour les tensions inférieures à un seuil de tension V4, est nulle pour les tensions supérieures à un seuil de tension V3, et décroît linéairement de 1 à 0 pour des tensions allant respectivement de V4 à V3.

Les seuils de tensions V1, V2, V3, et V4 sont représentatifs d'un courant ou d'une tension donné. Ces seuils V1 à V4 sont enregistrés dans la mémoire non volatile du calculateur 29 lors d'une phase d'apprentissage. C'est à dire que pendant la phase d'apprentissage, on branche les sondes 4 et 8 du compteur 1 sur un banc de mesure, puis on impose à la sonde de tension 4 une tension maximale qui donne la valeur du seuil V3 et on recommence l'opération avec une tension minimale pour avoir le seuil V4. Ainsi, les résistances 5 et 6 n'ont pas besoin d'avoir une grande précision car le processeur à logique floue rectifie lors de cette opération d'apprentissage les éventuelles dispersions sur les valeurs de ces résistances 5 et 6. Une opération similaire est faite sur la sonde de courant 8 afin d'obtenir les seuils V1 et V2. On note que là aussi la précision de la résistance importe peu (de ce fait on peut utiliser un vulgaire conducteur) et qu'il n'est pas nécessaire d'utiliser un amplificateur différentiel compliqué et coûteux pour compenser un éventuel décalage d'offset (phénomène bien connu qui additionne quelques millivolts à la sortie de l'amplificateur). L'homme du métier aura noté que les sondes 4 et 8 ne nécessitant pas une très grande précision sur les tolérances de valeurs, le coût de ces sondes 4 et 8 se voit fortement diminué.

Dans la pratique la tension minimale mesurable par le compteur est égale en valeur absolue à la tension maximale mesurable par le compteur, seul le signe de ces tensions est opposé. Il en est de même pour le courant minimal mesurable et le courant maximal mesurable. Si on appelle la puissance instantanée maximale mesurable Pmax qui est égale au produit du courant maximal mesurable par la tension maximale mesurable, alors on peut utiliser les règles suivantes:
- si le courant appartient à la fonction 31 et la tension appartient à la fonction 33 alors la puissance mesurée est Pmax,
- si le courant appartient à la fonction 32 et la tension appartient à la fonction 33 alors la puissance mesurée est -Pmax,
- si le courant appartient à la fonction 31 et la tension appartient à la fonction 34 alors la puissance mesurée est -Pmax,
- si le courant appartient à la fonction 32 et la tension appartient à la fonction 34 alors la puissance mesurée est Pmax.

Ces règles sont ensuite exploitées de manière pondérée en fonction de l'appartenance des mesures aux différentes fonctions d'appartenance 31 à 34, la somme pondéré de ces règles fournissant la décision de mesure de puissance. Autrement dit les fonctions d'appartenance 31 à 34 vont fixer des coefficients pondérateurs dépendant des valeurs réelles mesurées.

A titre d'exemple numérique, voici quelques valeurs qui se rapportent à un compteur d'appartement fonctionnant sous 220V efficace et 30A efficace:
- tension maximale instantanée = 350V,
- tension minimale instantanée = -350V,
- courant maximal instantané = 45A,
- courant minimal instantané = -45A,
- Pmax instantané = 15750W,
- seuil V1 réel = 4,8V,
- seuil V2 réel = -4,7V,
- seuil V3 réel = 4,5V,
- seuil V4 réel = -4,5V.

Si l'on effectue la mesure de la puissance consommée dans une charge entraînant un déphasage de π/6 et consommant 1A sous 220V en échantillonnant le courant et la tension toutes les millisecondes:
- la première mesure va s'effectuer pour une tension réelle de 0V soit un courant de 0,707A,
- la mesure de tension est de 0V et la mesure de courant est de 0,125V,
- le processeur à logique floue déduit des fonctions d'appartenances 31 à 34 que la mesure de courant appartient à 50,8% à la fonction 31 et à 49,2% à la fonction 32 et que la mesure de tension appartient à 50% à la fonction 33 et à 50% à la fonction 34,
- la décision est égale à (Pmax * 0,508 * 0,5) - (Pmax * 0,492 * 0,5) - (Pmax * 0,508 * 0,5) + (Pmax * 0,492 * 0,5) = 0.

La puissance instantanée ainsi mesurée est additionnée au résultat accumulé. On peut vérifier que sur une période, l'erreur vient surtout des arrondis réalisés pendant le calcul.

Dans le processeur à logique floue 17, l'erreur dépend en fait de trois paramètres:
- l'échantillonnage du courant et de la tension ne se fait pas en même temps car on ne dispose que d'un seul convertisseur analogique/numérique; en fait il y a un décalage de quelques ns, ce qui correspond à erreur inférieure à 3 pour 10000 par ns d'écart,
- les erreurs d'arrondis du processeur 18; pour une unité de calcul de 16 bits, cela correspond à moins de 1 pour 10000,
- les erreurs dues à la résolution du convertisseur analogique/numérique; cette erreur étant fixe, c'est elle qui détermine la précision du compteur.

Ainsi dans l'exemple de réalisation du présent document, on a une échelle de tension qui s'étend sur 700V et une échelle de courant qui s'étend sur 90A. On a pris des sondes peu précises à 10% de tolérance ce qui nous oblige de prévoir un balayage des entrées entre -4,5 V et +4,5 V au lieu d'un balayage de -5V à +5V sur les entrées. Néanmoins l'erreur pouvant être bilatérale sur les sondes, le balayage peut très bien ne s'effectuer qu'entre -4V et +4V; cela fait donc une perte de résolution de 20%. En échantillonnant les entrées sur 16 bits, cela donne une résolution dans l'exemple cité de 700 / (2¹⁶ / 0,8) = 8,5mV et 90 / (2¹⁶ / 0,8) = 1,1mA, soit moins de 10mW par mesure qui s'ajoute aux erreurs précités qui dépendent de la mesure. Dans l'exemple, la puissance consommé est de 190W, l'erreur fixe représente moins de 1 pour 10000. En cumulant toutes les erreurs, la mesure effectuée par le compteur est donc juste à moins de 0,1% près ce qui est très acceptable. De plus il existe des convertisseurs 16 bits donnant une précision de 1/2 LSB (de l'anglais Least Significant Bit), ce qui divise par quatre la résolution en puissance.

Un autre avantage de l'utilisation d'un processeur à logique floue 17 est l'étalonnage sur site. En effet le compteur est doté d'un connecteur 19. Si l'on désire effectuer un étalonnage sur site, un opérateur peut brancher une pince ampèremétrique de précision sur le fil 2 d'alimentation en sortie du compteur afin d'avoir une mesure très précise du courant et brancher une sonde de tension en entrée du compteur afin d'avoir une mesure très précise de la tension. Cette pince et cette sonde sont reliées à un boîtier de mesure lui-même connecté au compteur 1 par l'intermédiaire du connecteur 19. Un message envoyé par le boîtier de mesure signale que le compteur 1 doit fonctionner en mode d'étalonnage. Le processeur à logique floue 17 va donc envoyer des signaux de synchronisation correspondant à son échantillonnage en courant et en tension. Le boîtier de mesure utilise ces signaux de synchronisation pour lui-même échantillonner la mesure de courant qu'il effectue. Puis afin d'avoir une représentation de la dérive, on soustrait à la puissance instantanée mesurée par le compteur, la puissance instantanée mesurée par le boîtier. La dérive en puissance est en fait proportionnelle à la dérive en courant car la dérive de la sonde de tension 4 est quasiment inexistante. Cette dérive en puissance est mémorisée dans un registre interne du processeur à logique floue 17. Le processeur à logique floue additionnera lors de chaque mesure cette information de dérive en puissance à la décision prise par le calculateur. Il est également possible d'utiliser une fonction d'appartenance toujours égale à "1" pour réaliser la mémorisation et l'addition de cette dérive en puissance. En fait cette dérive correspond à un déplacement de la fonction de transfert de la sonde 8 par rapport à zéro (due au vieillissement de l'amplificateur). Pour plus de sûreté, on effectue la mesure une deuxième fois pour vérifier que l'écart n'est pas plus important que la résolution du compteur 1.

En ce qui concerne les autres entrées analogiques du processeur à logique floue 17, une entrée du processeur à logique floue 17 reçoit un signal de tarification modulé en courant porteur sur une bande de fréquence centrée sur 175 ou 188 Hz. Ce signal correspond à la porteuse d'une trame de 41 bits d'une durée de 103 secondes où les "1" sont codés par la présence de la fréquence porteuse. Le processeur à logique floue 17 est chargé d'identifier la trame et de réagir au niveau de la tarification. Pour cela, on associe des fonctions d'appartenance pour reconnaître le signal binaire. Afin de mémoriser l'information de tarification, on utilise un bit en interne qui indique quel est le compteur du système d'affichage 18 qui doit être utiliser pour stocker le prochain kilowattheure. Ce bit représentatif du message de tarification est stocké dans la mémoire du calculateur 29. L'échantillonnage se fait préférentiellement à 1 kHz (et non pas à un multiple de la porteuse) pour éviter d'avoir des fréquences d'échantillonnage qui risquent de pas être synchronisées et donc pouvant se chevaucher.

Une autre entrée reçoit un signal représentatif d'un message envoyé en courant porteur à une fréquence de 60 kHz. Un tel message n'est pas encore utilisé à l'heure actuelle mais peut servir à envoyer des ordres de télé-relevé, ou de changement de tarification plus complexe que heures creuses/heures pleines. L'utilisation d'un message en courant porteur sur une fréquence élevée, permet d'augmenter le débit et de rendre plus facile à filtrer les messages en courant porteur.

L'utilisation de courant porteur pour transmettre des informations permet de nombreuses possibilités. L'homme de métier peut se référer par exemple à la demande de brevet EP-A-0 678 995, ou encore à la demande de brevet déposé en France sous le numéro FR 94 15538 ou à la demande de brevet EP-A-0 718 954, pour avoir des informations complémentaires sur les possibilités offertes par des moyens de communication utilisant les courants porteurs conjointement à un compteur électrique.

De plus certaines variantes d'un tel compteur peuvent être envisagées. Tout d'abord, il est possible d'utiliser un système d'affichage qui n'utilise qu'un seul compteur. L'incrémentation se faisant en fonction de la tarification de manière plus ou moins rapide. C'est à dire que les décisions prises dans le processeur sont directement pondérées par la tarification en cours, ce qui est en fait la consommation ramenée en heure pleine ou plus simplement ramenée au prix réel.

Avec la variante précédente d'affichage du prix, on peut combiner un prix envoyé par courant porteur. C'est à dire qu'un message en courant porteur contiendrait directement un facteur de pondération relatif au prix.

Afin d'éviter les abus, il reste toujours possible de vérifier à partir du connecteur 19 certaines informations, notamment sur la tarification, contenues dans le processeur à logique floue 17.

Afin de réduire le nombre de composants dans le compteur 1, il est possible de supprimer le circuit 12. La fonction du circuit 12 étant de filtrer et démoduler des signaux en courant porteurs, le processeur à logique floue 17 devra alors démoduler de façon numérique les signaux venant de la sonde de tension 4.

L'exemple décrit concerne un compteur d'appartement de type monophasé. L'extension à un compteur de type triphasé est très simple, deux possibilités sont offertes: mesure de puissance sur deux phases ou mesure de puissance sur trois phases. La mesure sur deux phases présente comme avantage de n'utiliser que deux sondes de courant et deux sondes de tension; néanmoins un désavantage est une imprécision de la mesure qui est due à différents paramètres comme l'échantillonnage des phases qui doit être simultané, l'équilibrage supposé des phases, ou encore la résolution en tension dont la mesure s'effectue entre deux phases et non pas entre une phase et le neutre. La mesure sur trois phases présente comme avantage qu'il est possible de traiter de manière séparé le cas de chaque phase (l'une après l'autre) en ayant une précision identique à l'exemple décrit précédemment; le désavantage est d'utiliser trois sondes de tension et trois sondes de courant car on augmente le nombre de composants du compteur. Quelque soit le mode de réalisation choisit, il suffit de rajouter les sondes et de les connecter au processeur à logique floue en utilisant un commutateur analogique ayant des entrées supplémentaires.

L'extension de l'invention à des compteurs électriques triphasés présente les mêmes avantages que la version monophasé décrite plus en détail. L'étalonnage sur banc de mesure se verra augmenter en durée et consistera à répéter les mêmes opérations que pour un compteur monophasé en double ou en triple. Le recalibrage effectuera un contrôle des deux ou trois sondes de courant de la même manière que pour un compteur monophasé.

L'utilisation d'un compteur triphasé utilisant une mesure sur les trois phases est préférable car un tel compteur permet de contrôler l'équilibrage des phases de manière instantanée. Pour cela, on utilise trois variables stockées dans des registres internes du processeur à logique floue; ces variables correspondront pour chaque phase des sommations sur une période complète, par exemple sur 20 mesures successives, de la puissance instantanée, puis une comparaison des variables permettra de connaître les écarts de puissance entre les différentes phases.

On peut imaginer une tarification variable en fonction de l'équilibrage pour inciter les clients à utiliser au mieux leur installation électrique. Une ou plusieurs pondérations peuvent être utilisées et être modifiées par exemple à l'aide d'un message sur courant porteur.

## Revendications

1. Compteur de consommation électrique (1) comportant une première sonde de courant (8), une première sonde de tension (4) et un afficheur mémorisant son contenu (18), caractérisé en ce que ledit compteur (1) comporte un processeur à logique floue (17) ayant un calculateur (29) de prise de décision en logique floue disposant d'une mémoire non volatile pour stocker des fonctions d'appartenance correspondant aux premières sondes de tension et de courant (4 et 8) et pour stocker des règles de décision et en ce que ledit calculateur (29) prend une décision suivant lesdites règles qui est pondérée par les fonctions d'appartenance et qui a pour but d'incrémenter le contenu de l'afficheur (18).

2. Compteur (1) selon la revendication 1, caractérisé en ce que le processeur à logique floue (17) comporte un commutateur analogique (27) et un convertisseur analogique/numérique (28).

3. Compteur (1) selon l'une des revendications 1 ou 2, caractérisée en ce que le compteur (1) possède une entrée d'étalonnage (19) pour recevoir une information représentative d'une puissance mesurée par le compteur (1), et en ce que ladite entrée d'étalonnage (19) est reliée au processeur à logique floue (17).

4. Compteur (1) selon l'une des revendications 1 à 3, caractérisé en ce que le processeur à logique floue (17) comporte au moins une entrée d'information recevant un signal démodulé issu d'une modulation en courant porteur, et en ce que ladite information est identifiée par le calculateur (29) de prise de décision et est enregistrée dans la mémoire du calculateur (29).

5. Compteur (1) selon l'une des revendications 1 à 3, caractérisé en ce que le processeur à logique floue (17) recrée à partir des signaux issus des premières sondes de tension et de courant (4 et 8) une information modulé en courant porteur.

6. Compteur (1) selon l'une des revendications 1 à 5, caractérisé en ce qu'il comporte une deuxième sonde de courant et une deuxième sonde de tension qui mesurent des courant et tension différents des courant et tension mesurés par les premières sondes de tension et de courant (4 et 8), et en ce que ces sondes permettent au processeur à logique floue (17) de mesurer la consommation d'une installation triphasé.

7. Compteur (1) selon la revendication 6, caractérisé en ce qu'il comporte une troisième sonde de courant et une troisième sonde de tension, et en ce que:
- la première sonde de tension (4) mesure une tension entre une première phase et un neutre,
- la deuxième sonde de tension mesure une tension entre une deuxième phase et le neutre,
- la troisième sonde de tension mesure une tension entre une troisième phase et le neutre,
- une première sonde de courant (8) mesure le courant sur la première phase,
- une deuxième sonde de courant mesure le courant sur la deuxième phase,
- une troisième sonde de courant mesure le courant sur la troisième phase,
et en ce que le processeur à logique floue (17) prend des décisions relatives à la puissance consommée sur les première, deuxième et troisième phases.

8. Système de ré-étalonnage sur site d'un compteur de consommation électrique comprenant un compteur (1) tel que défini dans l'une des revendications 3 à 7 et comprenant un boîtier comportant une sonde étalon de courant et une sonde étalon de tension très précises, et des moyens pour être connecté à l'entrée d'étalonnage (19) du compteur (1).

9. Procédé d'utilisation du système de ré-étalonnage de la revendication 8, caractériséen ce qu'il comporte les étapes suivantes:
- connexion de la sonde étalon de tension en parallèle sur la première sonde de tension (4) du compteur (1),
- connexion de la sonde étalon de courant sur le même fil que la première sonde de courant (8) du compteur (1),
- échange d'une information de synchronisation entre le boîtier et le compteur (1) par l'intermédiaire de l'entrée d'étalonnage (19),
- mesure de la puissance instantanée par le compteur (1) et par le boîtier à un même instant,
- soustraction des puissances instantanées mesurées par le compteur et par le boîtier pour obtenir une information d'une dérive de la puissance,
- enregistrement dans le processeur à logique floue (17) du compteur (1) de l'information de dérive de la puissance.

## Patentansprüche

1. Stromverbrauchszähler (1), der eine erste Strommeßsonde (8), eine erste Spannungsmeßsonde (4) und ein Anzeigegerät (18) aufweist, das seinen Inhalt speichert, dadurch gekennzeichnet, daß der Zähler (1) einen Prozessor (17) mit unscharfer Logik enthält, der einen Rechner (29) zur Entscheidungsfindung gemäß unscharfer Logik aufweist, welcher über einen nicht-flüchtigen Speicher verfügt, um Zugehörigkeitsfunktionen zu speichern, die den ersten Spannungs- und Strommeßsonden (4 und 8) entsprechen, und um Entscheidungsregeln zu speichern, und daß der Rechner (29) eine Entscheidung gemäß diesen Regeln trifft, die durch die Zugehörigkeitsfunktionen gewichtet wird und die zum Ziel hat, den Inhalt des Anzeigegeräts (18) zu inkrementieren.

2. Zähler (1) nach Anspruch 1, dadurch gekennzeichnet, daß der Prozessor (17) mit unscharfer Logik ein analoges Schaltglied (27) und einen Analog/Digital-Wandler (28) aufweist.

3. Zänler (1) nach einem der Ansprüche 1 oder 2, dadurch gekennzeichnet, daß der Zähler (1) einen Eicheingang (19) aufweist, um eine Information zu empfangen, die für eine vom Zähler (1) gemessene Leistung repräsentativ ist, und daß dieser Eicheingang (19) mit dem Prozessor (17) mit unscharfer Logik verbunden ist.

4. Zähler (1) nach einem der Ansprüche 1 bis 3, dadurch gekennzeichnet, daß der Prozessor (17) mit unscharfer Logik mindestens einen Informationseingang enthält, der ein demoduliertes Signal empfängt, das von einer Trägerstrom-Modulation stammt, und daß diese Information vom Rechner (29) zur Entscheidungsfindung identifiziert und im Speicher des Rechners (29) gespeichert wird.

5. Zähler (1) nach einem der Ansprüche 1 bis 3, dadurch gekennzeichnet, daß der Prozessor (17) mit unscharfer Logik ausgehend von den Signalen, die von den ersten Spannungsund Strommeßsonden (4 und 8) kommen, eine Trägerstrommodulierte Information wiederherstellt.

6. Zähler (1) nach einem der Ansprüche 1 bis 5, dadurch gekennzeichnet, daß er eine zweite Strommeßsonde und eine zweite Spannungsmeßsonde aufweist, die einen anderen Strom und eine andere Spannung messen als die erste Spannungsmeßsonde und die erste Strommeßsonde (4 und 8), und daß diese Meßsonden es dem Prozessor (17) mit unscharfer Logik ermöglichen, den Verbrauch einer dreiphasigen Anlage zu messen.

7. Zähler (1) nach Anspruch 6, dadurch gekennzeichnet, daß er eine dritte Strommeßsonde und eine dritte Spannungsmeßsonde aufweist, und daß:
- die erste Spannungsmeßsonde (4) eine Spannung zwischen einer ersten Phase und einem Nulleiter mißt,
- die zweite Spannungsmeßsonde eine Spannung zwischen einer zweiten Phase und dem Nulleiter mißt,
- die dritte Spannungsmeßsonde eine Spannung zwischen einer dritten Phase und dem Nulleiter mißt,
- eine erste Strommeßsonde (8) den Strom im ersten Phasenleiter mißt,
- eine zweite Strommeßsonde den Strom im zweiten Phasenleiter mißt,
- eine dritte Strommeßsonde den Strom im dritten Phasenleiter mißt,
und daß der Prozessor (17) mit unscharfer Logik Entscheidungen in Bezug auf die im ersten, zweiten und dritten Phasenleiter verbrauchte Leistung trifft.

8. System zur Nacheichung eines Stromverbrauchszählers vor Ort, der einen wie in einem der Ansprüche 3 bis 7 definierten Zähler (1) aufweist und ein Gehäuse besitzt, das eine sehr präzise Eichungs-Strommeßsonde und eine sehr präzise Eichungs-Spannungsmeßsonde und Mittel enthält, die an den Eicheingang (19) des Zählers (1) angeschlossen werden können.

9. Verfahren zur Anwendung des Systems zur Nacheichung gemäß Anspruch 8, dadurch gekennzeichnet, daß es die folgenden Schritte aufweist:
- paralleler Anschluß der Eichungs-Spannungsmeßsonde an die erste Spannungsmeßsonde (4) des Zählers (1),
- Anschluß der Eichungs-Strommeßsonde an den gleichen Draht wie die erste Strommeßsonde (8) des Zählers (1),
- Austausch einer Synchronisierungsinformation zwischen dem Gehäuse und dem Zähler (1) über den Eicheingang (19),
- Messung der momentanen Leistung durch den Zähler (1) und durch das Gehäuse zu einem gleichen Zeitpunkt,
- Vergleich der vom Zähler und vom Gehäuse gemessenen momentanen Leistungen, um eine Information über eine Abweichung der Leistungsmessung zu erhalten,
- Speicherung der Information über die Abweichung der Leistungsmessung im Prozessor (17) mit unscharfer Logik des Rechners (1).

## Claims

1. An electricity meter (1) comprising a first current detector (8), a first voltage detector (4) and a display panel memorising its contents (18),
**characterised in that** the said meter (1) comprises a fuzzy logic processor (17) having a fuzzy logic decision-taking calculator (29) disposing of a nonvolatile memory for storing membership functions corresponding to the first voltage and current detectors (4 and 8) and for storing decision rules, **and in that** the said calculator (29) takes a decision according to the said rules which is adjusted by the membership functions and the purpose of which is to increment the contents of the display panel (18).

2. A meter according to Claim 1,
**characterised in that** the fuzzy logic processor (17) comprises an analog switch (27) and an analog to digital converter (28).

3. A meter (1) according to one of Claims 1 or 2,
**characterised in that** the meter (1) possesses a calibration input (19) for receiving an item of information representative of a power measured by the meter (1),
**and in that** the said calibration input (19) is connected to the fuzzy logic processor (17).

4. A meter (1) according to one of Claims 1 to 3,
**characterised in that** the fuzzy logic processor (17) comprises at least one information input receiving a demodulated signal derived from a carrier current modulation,
**and in that** the said item of information is identified by the decision-taking calculator (29) and is recorded in the memory of the calculator (29).

5. A meter (1) according to one of Claims 1 to 3,
**characterised in that** the fuzzy logic processor (17) recreates from the signals derived from the first voltage and current detectors (4 and 8) a carrier current modulated item of information.

6. A meter (1) according to one of Claims 1 to 5,
**characterised in that** it comprises a second current detector and a second voltage detector which measure current and voltage different from the current and voltage measured by the first voltage and current detectors (4 and 8), **and in that** these detectors enable the fuzzy logic processor (17) to measure the power consumption of a three-phase installation.

7. A meter (1) according to Claim 6,
**characterised in that** it comprises a third current detector and a third voltage detector,
**and in that:**
- the first voltage detector (4) measures a voltage between a first phase and a neutral,
- the second voltage detector measures a voltage between a second phase and the neutral,
- the third voltage detector measures a voltage between a third phase and the neutral,
- a first current detector (8) measures the current in the first phase,
- a second current detector measures the current in the second phase,
- a third current detector measures the current in the third phase,
**and in that** the fuzzy logic processor (17) takes decisions regarding the power consumption in the first, second and third phases.

8. A system for the on-site recalibration of an electricity meter comprising a meter (1) as defined in one of Claims 3 to 7 and comprising a housing having a standard current detector and a standard voltage detector, which are very precise, and means to be connected to the calibration input (19) of the meter (1).

9. A method for using the recalibration system of Claim 8,
**characterised in that** it comprises the following steps:
- connection of the standard voltage detector in parallel on the first voltage detector (4) of the meter (1),
- connection of the standard current detector on the same wire as the first current detector (8) of the meter (1)
- exchange of an item of synchronisation information between the housing and the meter (1) by means of the calibration input (19),
- measurement of the instantaneous power by the meter (1) and by the housing at the same instant,
- subtraction of the instantaneous power values measured by the meter and by the housing to obtain an item of information on a deviation of the power,
- recording the deviation information of the power in the fuzzy logic processor (17) of the meter (1).
